# EUROPEAN PATENT APPLICATION

(11) **EP 4 386 516 A1**
(43) Date of publication of application: **19.06.2024**
(21) Application number: 22871671.8
(22) Date of filing: 12.08.2022
(51) Int. Cl.: G06F 1/20

(54) **HEAT DISSIPATION DEVICE AND SERVER**

(30) Priority: 27.09.2021 CN 202111135533
(71) Applicant: Huawei Technologies Co., Ltd., Shenzhen, Guangdong 518129 (CN)
(72) Inventor: LIU, Weiming, Shenzhen, Guangdong 518129 (CN); CHI, Shanjiu, Shenzhen, Guangdong 518129 (CN); LU, Xiaoxiao, Shenzhen, Guangdong 518129 (CN)
(74) Representative: Pfenning, Meinig & Partner mbB
(86) International application number: PCT/CN2022/112197
(87) International publication number: WO 2023/045613

(57) **Abstract**

A heat dissipation apparatus including an air-cooling structure and a liquid-cooling structure, and a server are provided. The air-cooling structure is configured to simultaneously perform air cooling on a first-type component and a second-type component, and the liquid-cooling structure is configured to perform liquid cooling on the first-type component, where heat generated by the first-type component is higher than heat generated by the second-type component. The liquid-cooling structure specifically includes a liquid-cooling assembly (21) and a heat exchanger (22). The liquid-cooling assembly (21) can conduct the heat generated by the first-type component into a coolant in a liquid-cooling pipe (211) of the liquid-cooling assembly (21). The heat exchanger (22) is configured for heat exchange between the coolant and external air, and the heat exchanger (22) herein is disposed at a tail end of the server. The heat exchanger (22) is disposed at the tail end of the server, so that heat dissipation air generated during heat exchange does not affect heat dissipation of other components of the server. This can implement effective heat management and improve a heat dissipation capability of the server.

## Description

### CROSS-REFERENCE TO RELATED APPLICATIONS

This application claims priority to Chinese Patent Application No. 202111135533.7, filed with Chinese National Intellectual Property Administration on September 27, 2021 and entitled "HEAT DISSIPATION APPARATUS AND SERVER", which is incorporated herein by reference in its entirety.

### TECHNICAL FIELD

This application relates to the field of server technologies, and in particular, to a heat dissipation apparatus and a server.

### BACKGROUND

With the development of science and technology, performance of a processor in an electronic device such as a server is continuously improved, and power consumption of the processor is increasingly high. Therefore, higher requirements are imposed on heat dissipation of the electronic device. However, a conventional air-cooling heat sink cannot sufficiently resolve a problem of heat dissipation of the processor.

To improve a heat dissipation effect, components such as a processor with high power consumption may be alternatively cooled through air cooling and auxiliary liquid cooling. However, due to a limitation of a structural layout, high-temperature outlet air from a heat sink affects heat dissipation of these functional components. Therefore, how to provide a more efficient heat dissipation apparatus is an urgent technical problem to be resolved.

### SUMMARY

This application provides a heat dissipation apparatus and a server, to improve a heat dissipation capability of the server.

According to a first aspect, this application provides a heat dissipation apparatus that may be used in a server. The heat dissipation apparatus includes an air-cooling structure and a liquid-cooling structure, and performs heat dissipation on the server in an air-cooling and liquid-cooling manner. It is assumed that a first-type component and a second-type component are disposed in a setting server. Heat generated by the first-type component is higher than heat generated by the second-type component. The first-type component may be a component such as a processor with high heat dissipation, and the second-type component may be a component such as a PCIe (peripheral component interconnect express, peripheral component interconnect express) card. The air-cooling structure in the heat dissipation apparatus provided in this application is configured to simultaneously perform air-cooling on the first-type component and the second-type component, and the liquid-cooling structure is configured to perform targeted liquid cooling on the first-type component. The liquid-cooling structure specifically includes: a liquid-cooling assembly and a heat exchanger. The liquid-cooling assembly may conduct the heat generated by the first-type component to a coolant in a liquid supply pipe of the liquid-cooling assembly; and the heat exchanger is configured for heat exchange between the coolant and external air, and the heat exchanger herein is disposed at a tail end of the server.

The heat dissipation apparatus provided in this application performs heat dissipation on the first-type component and the second-type component in the server in the air-cooling and liquid-cooling manner. The liquid-cooling structure may perform targeted heat dissipation on the first-type component with high heat dissipation. The heat exchanger is disposed at the tail end of the server, so that heat dissipation air generated during heat exchange does not affect heat dissipation of another component of the server. This implements effective heat management and improves a heat dissipation capability of the server.

The heat exchanger has a heat exchange inner cavity and a liquid replenishment cavity located at the top of the heat exchange inner cavity. The heat exchange inner cavity has a liquid inlet for the coolant to flow in and a liquid outlet for the coolant to flow out. The liquid replenishment cavity is filled with the coolant, and the liquid replenishment cavity is connected to the heat exchange inner cavity through a liquid replenishment channel. Specifically, a volume of the coolant in the liquid replenishment cavity is not less than a liquid volume threshold, and the liquid volume threshold is a liquid loss of the coolant within a service life of the heat dissipation apparatus.

In specific implementation, the foregoing air-cooling structure may form an air duct in a chassis of the server. The heat exchanger of the liquid-cooling structure is disposed at an air outlet of the air duct, and does not have an adverse effect on heat dissipation of another component.

In a possible implementation, the air-cooling structure includes a separator. The separator separates a cavity of the server into at least two air ducts, and the at least two air ducts include a first air duct and a second air duct; and the heat exchanger is located at an air outlet of the first air duct. The first-type component and the second-type component may be disposed in the second air duct, so that temperature cascading can be reduced and the heat dissipation capability can be improved. A material of the separator may be sheet metal or plastic.

The air-cooling structure may further include a heat dissipation fan. The heat dissipation fan is specifically located on an air inlet side of the heat exchanger to provide stronger airflow for the heat exchanger and improve an air-cooling effect. To improve the heat dissipation capability, the liquid-cooling structure may further include an auxiliary heat exchanger. Specifically, the auxiliary heat exchanger may be disposed in the first air duct and connected to the heat exchanger in series.

Specifically, the separator is parallel to a PCB in the server, and a distance between the separator and the highest component on the PCB is less than a height threshold. The height threshold ensures a good air-cooling effect on any component on the circuit board in the air duct. Possibly, in a direction perpendicular to the separator, a plurality of mounting positions are disposed in the server, and the separator is detachably mounted at any one of the mounting positions, to adjust a height of the separator based on different application scenarios.

In a possible implementation, the liquid-cooling assembly may specifically include a liquid-cooling pipe, the coolant, and a circulating pump. The liquid-cooling pipe is connected to the heat exchanger, and the coolant is filled in the liquid-cooling pipe and the heat exchanger. The circulating pump is connected to the liquid-cooling pipe to drive the coolant to circulate between the heat exchanger and the liquid-cooling pipe.

To improve a liquid-cooling effect on the first-type component, the liquid-cooling assembly may further include a cold plate, and part of the liquid-cooling pipe is encapsulated in the cold plate. The cold plate is configured to contact the first-type component, to facilitate heat exchange between the first-type component and the coolant in the liquid-cooling pipe.

In a possible implementation, the circulating pump is located at a high position. When the separator is fastened in the cavity of the server, a hollow-out region may be disposed on the separator, and the hollow-out region may avoid the circulating pump. This isolates the air duct and does not affect liquid cooling.

According to a second aspect, this application provides a server. The server includes a first-type component, a second-type component, and any one of the foregoing heat dissipation apparatuses.

In this application, based on the implementations according to the foregoing aspects, the implementations may be further combined to provide more implementations.

### BRIEF DESCRIPTION OF DRAWINGS

FIG. 1 is a schematic structural diagram of a heat dissipation apparatus used in a server according to an embodiment of this application;
FIG. 2 is another schematic structural diagram of a heat dissipation apparatus used in a server according to an embodiment of this application;
FIG. 3 is a schematic structural diagram of a mounting position at which a mounting position of a separator in a heat dissipation apparatus is adjusted according to an embodiment of this application in a chassis of a server;
FIG. 4 is a schematic structural diagram of a heat exchanger in a heat dissipation apparatus according to an embodiment of this application;
FIG. 5 is another schematic structural diagram of a heat exchanger in a heat dissipation apparatus according to an embodiment of this application;
FIG. 6 is a schematic structural diagram of a heat dissipation apparatus used in a server according to an embodiment of this application;
FIG. 7 is a schematic structural diagram of encapsulating a cold plate and a liquid-cooling pipe in a heat dissipation apparatus according to an embodiment of this application;
FIG. 8 is another schematic structural diagram of encapsulating a cold plate and a liquid-cooling pipe in a heat dissipation apparatus according to an embodiment of this application;
FIG. 9 is a schematic structural diagram of a heat dissipation apparatus used in a server according to an embodiment of this application;
FIG. 10 is a schematic structural diagram of performing heat dissipation on a processor by a liquid-cooling structure in a heat dissipation apparatus according to an embodiment of this application;
FIG. 11 is another schematic structural diagram of performing heat dissipation on a processor by a liquid-cooling structure in a heat dissipation apparatus according to an embodiment of this application;
FIG. 12 is another schematic structural diagram of performing heat dissipation on a processor by a liquid-cooling structure in a heat dissipation apparatus according to an embodiment of this application;
FIG. 13 is another schematic structural diagram of performing heat dissipation on a processor by a liquid-cooling structure in a heat dissipation apparatus according to an embodiment of this application;
FIG. 14 is another schematic structural diagram of performing heat dissipation on a processor by a liquid-cooling structure in a heat dissipation apparatus according to an embodiment of this application;
FIG. 15 is a schematic structural diagram of a heat dissipation apparatus used in a server according to an embodiment of this application;
FIG. 16 is a schematic structural diagram of a heat dissipation apparatus laid out into a server according to an embodiment of this application;
FIG. 17 is another schematic structural diagram of a heat dissipation apparatus laid out into a server according to an embodiment of this application;
FIG. 18 is another schematic structural diagram of a heat dissipation apparatus laid out into a server according to an embodiment of this application; and
FIG. 19 is a schematic structural diagram of a heat dissipation apparatus laid out into a server according to an embodiment of this application.

### DESCRIPTION OF EMBODIMENTS

A conventional server is generally cooled through air cooling and auxiliary liquid cooling. However, due to a limitation of a structural space layout, liquid cooling and air cooling affect each other, resulting in a poor heat dissipation effect.

The following further describes this application in detail with reference to accompanying drawings.

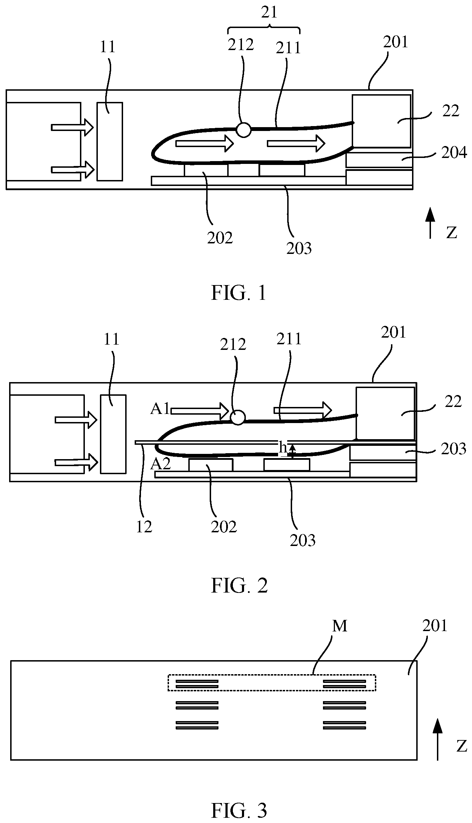

A first-type component and a second-type component are disposed in a chassis 201 of a server shown in FIG. 1. Heat generated by the first-type component is higher than heat generated by the second-type component. The first-type component may be a component such as a processor 202 with high power consumption and relatively high heat dissipation, and the second-type component may be a component such as a PCIe card 204 with low power consumption and relatively low heat dissipation. Generally, a PCB (print circuit board, print circuit board) 203 is disposed in the chassis 201, the processor 202 is coupled to the PCB 203, and the PCIe card 204 is located in the chassis 201 and inserted into the PCB 203. Because the heat generated by the first-type component and the heat generated by the second-type component is different, different heat dissipation manners may be used for the first-type component and the second-type component.

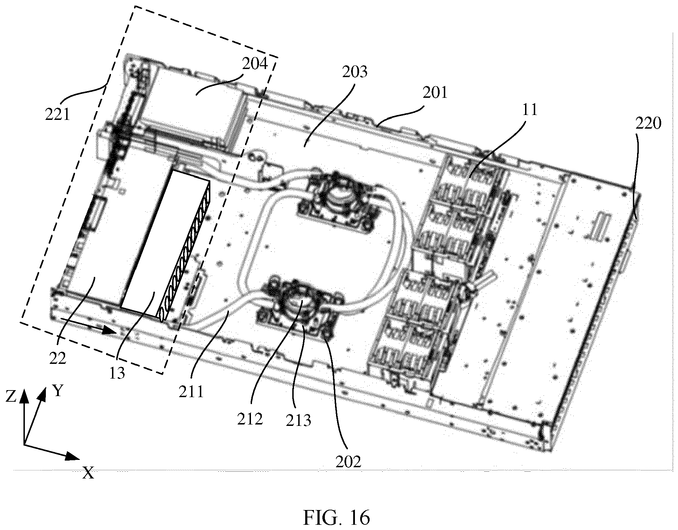

Still refer to FIG. 1. A heat dissipation apparatus provided in this application includes an air-cooling structure and a liquid-cooling structure to implement air cooling and liquid cooling. The air-cooling structure includes a system fan 11. The system fan 11 may be specifically disposed at a relatively front end of the chassis 201. The system fan 11 may form a heat dissipation air duct in the chassis 201 to dissipate heat of the first-type component and the second-type component in an air-cooling manner. Herein, a "tail end" and a "front end" of the chassis 201 of the server are relative position concepts. Refer to the server shown in FIG. 1. The system fan 11 forms the heat dissipation air duct in the chassis 201 along a direction of airflow in the heat dissipation duct. The tail end of the chassis 201 refers to a position close to a rear panel of the server. With reference to a top view of an entire system structure shown in FIG. 16, a region on the right in the chassis 201 is a front panel 220, and the tail end of the chassis 201 refers to an end side opposite to the front panel 220. For example, a range indicated by a region 221 in the figure may be referred to as the tail end of the chassis 201.

The liquid-cooling structure performs liquid cooling on the first-type component, and specifically includes a liquid-cooling assembly 21 and a heat exchanger 22. The liquid-cooling assembly 21 has a liquid-cooling pipe 211 and a circulating pump 212 connected to the liquid-cooling pipe 211. The liquid-cooling pipe 211 is connected to the heat exchanger 22, and the liquid-cooling pipe 211 and the heat exchanger 22 are filled with a coolant to form a closed circulation system. The circulating pump 212 may drive the coolant to circulate between the liquid-cooling pipe 211 and the heat exchanger 22. A path of the liquid-cooling pipe 211 is disposed to pass through the first-type component (where the processor 202 is used as an example), so that heat dissipated by the processor 202 can be absorbed into the coolant. Driven by the circulating pump 212, the coolant absorbing the heat moves to the heat exchanger 22. The heat exchanger 22 is configured for heat exchange between the coolant and external air. The cooled coolant is driven back to the liquid-cooling pipe 211 by the circulating pump 212, to implement liquid-cooling circulation of the coolant to the first-type component. The heat exchanger 22 is disposed at a tail end of the server, and heat dissipated by the heat exchanger 22 can directly contact the outside without affecting heat dissipation of another component (including, but not limited to, the first-type component and the second-type component). In FIG. 1, along a height direction Z of the chassis 201 of the server, the heat exchanger 22 and the PCIe card 204 are in parallel.

To facilitate heat management, refer to FIG. 2. The air-cooling structure further includes a separator 12. The separator 12 may separate a cavity of the chassis 201 of the server into at least two air ducts: a first air duct A1 and a second air duct A2. The separator 12 extends in a direction of outlet airflow of the system fan 11. That the heat exchanger 22 may be specifically disposed at an air outlet of the first air duct A1 is equivalent to that air cooling on the heat exchanger 22 is performed only through the first air duct A1. The first-type component (using the processor 202 as an example) and the second-type component (using the PCIe card 204 as an example) are disposed in the second air duct A2, and air cooling on the first-type component and the second-type component is performed only through the second air duct A2. The separator 12 is disposed to separate the air cooling on the heat exchanger 22 from the air cooling on the first-type component and the second-type component, so that temperature cascading of the heat dissipation structure can be reduced, and a heat dissipation capability of a bottleneck component can be improved. A material of the separator 12 is not limited, and may be specifically sheet metal or plastic.

The separator 12 may be parallel to the PCB 203 in the server, and a distance between the separator 12 and the highest component on the PCB 203 is less than or equal to a height threshold h. Assuming that the highest component on the PCB 203 is the processor 202, a distance between the separator 12 and a surface of the processor 202 away from the PCB 203 should not be greater than the height threshold h. The height threshold h can ensure that all components in the second air duct A2 can implement air cooling.

When different components may be disposed in the server, heights of the components located in the second air duct A2 may be different, so that a position of the separator 12 in the chassis 201 may be adjusted. As shown in FIG. 3, along a thickness direction Z of the separator 12, a plurality of mounting positions may be disposed in the chassis 201 of the server, and the separator 12 may be detachably mounted at any one of the mounting positions as required. The mounting position herein is a position at which the separator 12 can be fastened to the chassis 201. When the separator 12 is mounted at one mounting position, the separator 12 has a corresponding position in the chassis 201. This position is related to a horizontal height of the separator 12 in the chassis 201 along the height direction Z of the chassis 201, in other words, one mounting position is equivalent to one relative horizontal height of the separator 12 in the chassis 201. For example, each mounting position may be a bayonet group M formed on inner walls of two sides of the chassis 201 parallel to the direction Z. The bayonet group M has a slot for accommodating an edge of the separator 12. The edge of the separator 12 is inserted into the slot formed by the bayonet group M, so that the separator 12 can be fastened in the chassis 201. In such a structural design, a ventilation quantity in the first air duct A1 and the second air duct A2 may be further adjusted by adjusting the position of the separator 12 in the chassis 201.

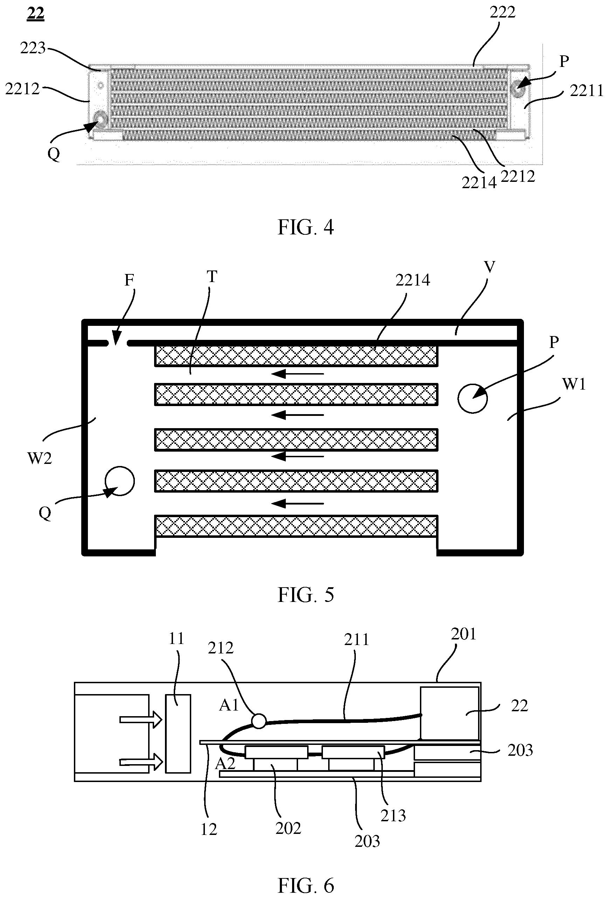

For a structure of the heat exchanger 22, refer to a structure of the heat exchanger 22 shown in FIG. 4. The heat exchanger 22 includes a liquid inlet tank 2211, a liquid outlet tank 2212, a circulation pipe 2213, and a liquid replenishment tank 222. The liquid inlet tank 2211 has an inlet port P for receiving the coolant delivered from the liquid-cooling pipe 211, and the liquid outlet tank 2212 has a liquid outlet Q for delivering the coolant to the liquid-cooling pipe 211. The liquid inlet tank 2211 is connected to the liquid outlet tank 2212 through at least one circulation pipe 2213, where a plurality of circulation pipes 2213 are arranged in parallel. A heat dissipation fin 2214 is disposed on an outer surface of the circulation pipe 2213, and the heat dissipation fin 2214 is shown in a corrugated shape (certainly, the heat dissipation fin 2214 may alternatively be in another shape). The liquid replenishment tank 222 is located at the top of the heat exchanger 22, and the liquid replenishment tank 222 is connected to the liquid outlet tank 2212 through a liquid replenishment pipe 223. The liquid replenishment tank 222 is welded to the top of the liquid outlet tank 2212.

Refer to an internal structure of the heat exchanger 22 shown in FIG. 5. The heat exchanger 22 is equivalent to being formed with a heat exchange inner cavity. The heat exchange inner cavity specifically includes a liquid inlet cavity W1 formed by the liquid inlet tank 2211, a liquid outlet cavity W2 formed by the liquid outlet tank 2212, and a circulation channel T formed by the circulation pipe 2213. The liquid inlet cavity W1 passes through the liquid inlet P and the liquid-cooling pipe 211, and the coolant that absorbs the heat dissipated from the first-type component enters the liquid inlet cavity W1 from the liquid inlet P. A plurality of circulation channels T are arranged in parallel between the liquid inlet cavity W1 and the liquid outlet cavity W2, and the coolant may enter the liquid outlet cavity W2 from the liquid inlet cavity W1 through the circulation channels T. When an air-cooling airflow passes through the heat exchanger 22, the coolant with a relatively high temperature in the circulation channels T may exchange heat with the external air to implement air cooling. The coolant finally enters the liquid outlet cavity W2 with a relatively low temperature. The liquid outlet cavity W2 is connected to the liquid-cooling pipe 211 through the liquid outlet Q. The coolant with a relatively low temperature in the liquid outlet cavity W2 may enter the liquid-cooling pipe 211 through the liquid outlet Q, and flow along the liquid-cooling pipe 211 to perform liquid cooling on the first-type component. The heat dissipation fin 2214 disposed on an outer surface of the circulation channel T can increase a heat dissipation area and improve a heat dissipation effect.

In a possible implementation, the heat exchanger 22 further includes a liquid replenishment cavity V formed by the liquid replenishment tank 222, and the liquid replenishment cavity V is prefilled with a coolant. The liquid replenishment cavity V is specifically located at the top of the heat exchange inner cavity, and the liquid replenishment cavity V is connected to the heat exchange inner cavity through a liquid replenishment channel F formed by the liquid replenishment pipe 223. The coolant in the liquid-cooling pipe 211 is lost to some extent due to a material of the liquid-cooling pipe 211. The coolant in the liquid replenishment cavity V may enter the heat exchange inner cavity through the liquid replenishment channel F under gravity, to ensure that the coolant is sufficient for implementing liquid-cooling circulation. Generally, the liquid replenishment cavity V is connected to the liquid outlet cavity W2 through the liquid replenishment channel F, and the coolant may be directly replenished into the coolant obtained through air cooling.

During operation of the heat dissipation apparatus, the coolant circulates in the closed circulation system formed by the liquid-cooling structure, and part of liquid may adhere to an inner wall of the heat exchanger 22 and the inside of the liquid-cooling pipe 211. In addition, a small amount of the coolant may also evaporate and leak due to a material of each part of the liquid-cooling structure (certainly, the loss is very small). Based on this aspect, a liquid volume threshold may be set for a volume of the coolant in the liquid replenishment cavity V, and the liquid volume threshold may be estimated based on a volume of the coolant emitted throughout the entire liquid-cooling structure in unit time and a service life of the heat dissipation apparatus. Theoretically, the liquid volume threshold is at least not less than the volume estimated based on the volume of the coolant emitted throughout the liquid-cooling structure in unit time and the service life of the heat dissipation apparatus, to avoid degradation of heat dissipation performance caused by a liquid volume loss.

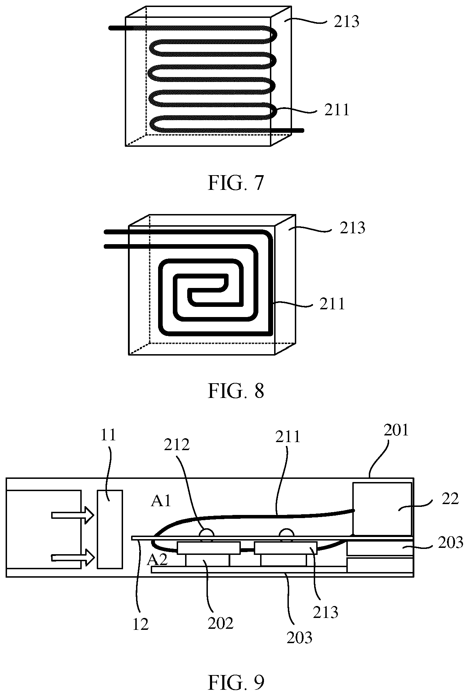

The liquid-cooling pipe 211 in the liquid-cooling assembly 21 is generally a hose, which facilitates layout based on a location of the processor 202. However, it is inconvenient for such a liquid-cooling pipe 211 to contact for heat exchange with the first-type component (where the processor 202 is used as an example). As shown in FIG. 6, part of the liquid-cooling pipe 211 for heat dissipation with the first-type component may be encapsulated in a cold plate 213. The part of the liquid-cooling pipe 211 may be densely disposed in the cold plate 213 (for example, serpentine distribution shown in FIG. 7 or cyclotron distribution shown in FIG. 8). The cold plate 213 is fastened by contacting the first-type component or being close to the first-type component, so that more sufficient heat exchange between the coolant in the liquid-cooling pipe 211 in the cold plate 213 and the first-type component can be implemented, thereby achieving a good liquid-cooling effect on the first-type component. Generally, there are a plurality of first-type components in the server (where at least two processors 202 are used as an example), and a plurality of cold plates 213 may be disposed, so that the cold plates 213 may exchange heat with the processors 202 in a one-to-one correspondence manner. It should be understood that the cold plate 213 is located in the second air duct A2 to be close to the processor 202.

To ensure smooth flow of the coolant between the liquid-cooling pipe 211 and the heat exchanger 22, a plurality of circulating pumps 212 are disposed. As shown in FIG. 9, each processor 202 may correspond to one circulating pump 212, and the circulating pump 212 may be specifically fastened on a surface of the cold plate 213. With reference to the foregoing embodiment, a maximum distance between the separator 12 and the highest component on the PCB 203 is the height threshold h, to ensure an air-cooling effect and a compact structure. The processor 202 already has a relatively high height after being added with the cold plate 213, and the cold plate 213 is very close to the separator 12. The circulating pump 212 is disposed on the cold plate 213. If the circulating pump 212 protrudes from the separator 12, a hollow-out structure capable of avoiding the circulating pump 212 may be provided on the separator 12. The hollow-out structure can avoid the circulating pump 212, so that the circulating pump 212 can partially enter the first air duct A1.

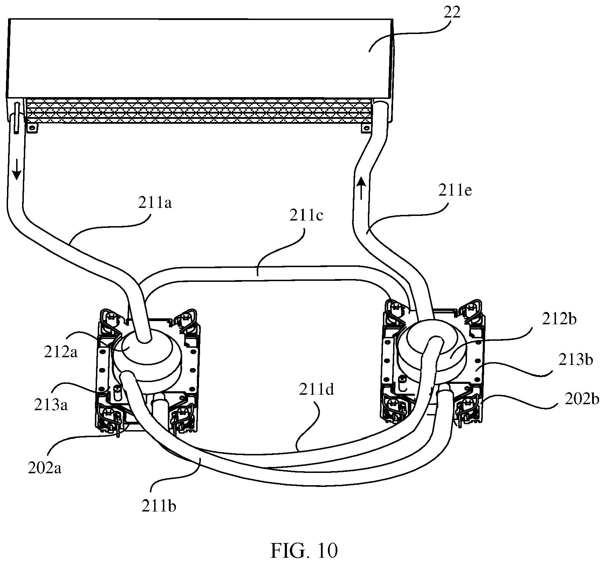

In the foregoing embodiment, one circulating pump 212 is configured for each first-type component, and when there are at least two first-type components, there are also two circulating pumps 212. When the liquid-cooling structure performs liquid cooling on the plurality of first-type components, that the first-type component is the processor 202 is used as an example. For a liquid flow path of the coolant in the liquid-cooling pipe 211, there may be a plurality of implementations as shown in FIG. 10 to FIG. 14, where the processors 202, the cold plates 213, and the circulating pumps 212 are set to two and are in a one-to-one correspondence, and the liquid-cooling pipe 211 is structurally divided based on different parts.

Refer to FIG. 10. The coolant flowing out of the heat exchanger 22 enters a first circulating pump 212a through a liquid-cooling pipe 211a, enters a second cold plate 213b from the first circulating pump 212a through a liquid-cooling pipe 211b, enters a first cold plate 213a from the second cold plate 213b through a liquid-cooling pipe 211c, enters a second circulating pump 212b from the first cold plate 213a through a liquid-cooling pipe 211d, and returns to the heat exchanger 22 from the second circulating pump 212b through a liquid-cooling pipe 211e. This structure does not limit the flow path of the coolant, and in actual operation, a sequence of liquid inlet and outlet between the circulating pump 212 and the cold plate 213 may be adjusted as needed.

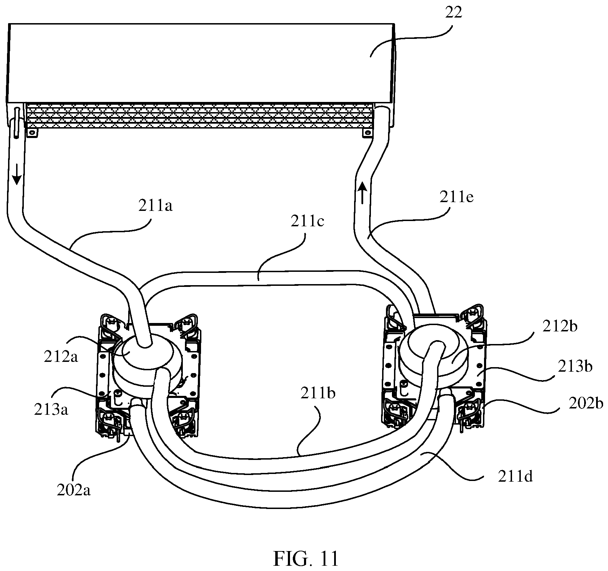

Refer to FIG. 11. The coolant flowing out of the heat exchanger 22 enters a first circulating pump 212a through a liquid-cooling pipe 211a, enters a second circulating pump 212b from the first circulating pump 212a through a liquid-cooling pipe 211b, enters a first cold plate 213a from the second circulating pump 212b through a liquid-cooling pipe 211c, enters a second cold plate 213b from the first cold plate 213a through a liquid-cooling pipe 211d, and returns to the heat exchanger 22 from the second cold plate 213b through a liquid-cooling pipe 211e. This structural design is equivalent to that the coolant first passes through the two circulating pumps 212, and then passes through the two cold plates 213, to perform liquid cooling on the processor 202. The two cold plates 213 are connected in series.

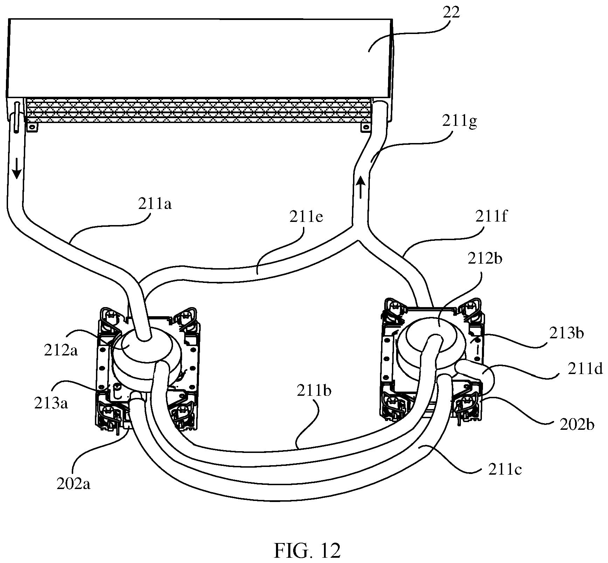

Refer to FIG. 12. The coolant flowing out of the heat exchanger 22 enters a first circulating pump 212a through a liquid-cooling pipe 211a, and then enters a second circulating pump 212b from the first circulating pump 212a through a liquid-cooling pipe 211b. The second circulating pump 212b has two outlets, one outlet enters a first cold plate 213a through a liquid-cooling pipe 211c, and the other enters a second cold plate 213b through a liquid-cooling pipe 211d. The coolant in the first cold plate 213a enters a liquid-cooling pipe 211e, and the coolant in the second cold plate 213b enters a liquid-cooling pipe 211f. The liquid-cooling pipe 211e and the liquid-cooling pipe 211f are joined together and then integrated into a liquid-cooling pipe 211g, and the liquid-cooling pipe 211g leads the coolant into the heat exchanger 22. This structural design is equivalent to that the coolant first passes through the two circulating pumps 212, and then passes through the two cold plates 213, to perform liquid cooling on the processor 202. The two cold plates 213 are connected in parallel.

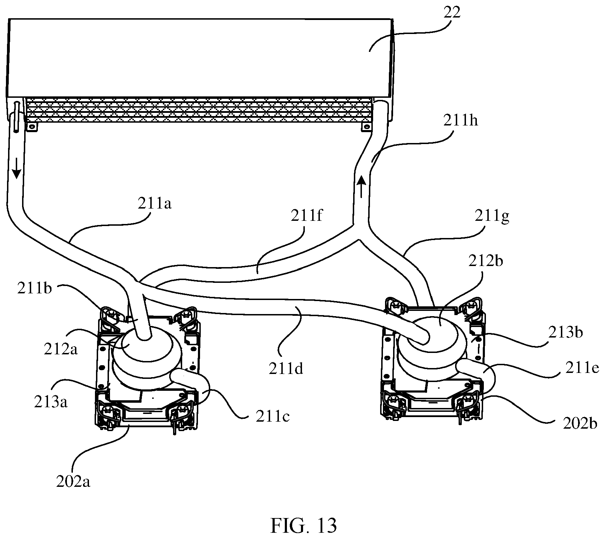

Refer to FIG. 13. The coolant flowing out of the heat exchanger 22 passes through a liquid-cooling pipe 211a and then splits into two branches. The coolant in one branch enters a first circulating pump 212a through a liquid-cooling pipe 211b, and then enters a first cold plate 213a from the first circulating pump 212a through a liquid-cooling pipe 211c. The coolant in the other branch enters a second circulating pump 212b through a liquid-cooling pipe 211d, and then enters a second cold plate 213b through a liquid-cooling pipe 211e from the second circulating pump 212b. The coolant in the first cold plate 213a enters a liquid-cooling pipe 211f, and the coolant in the second cold plate 213b enters a liquid-cooling pipe 211g. The liquid-cooling pipe 211f and the liquid-cooling pipe 211g are joined together and then integrated into the liquid-cooling pipe 211h, and the liquid-cooling pipe 211h leads the coolant into the heat exchanger 22. This structural design is equivalent to serving one circulating pump 212 corresponding to one cold plate 213 as one set of cooling units, and the cooling units are connected in parallel.

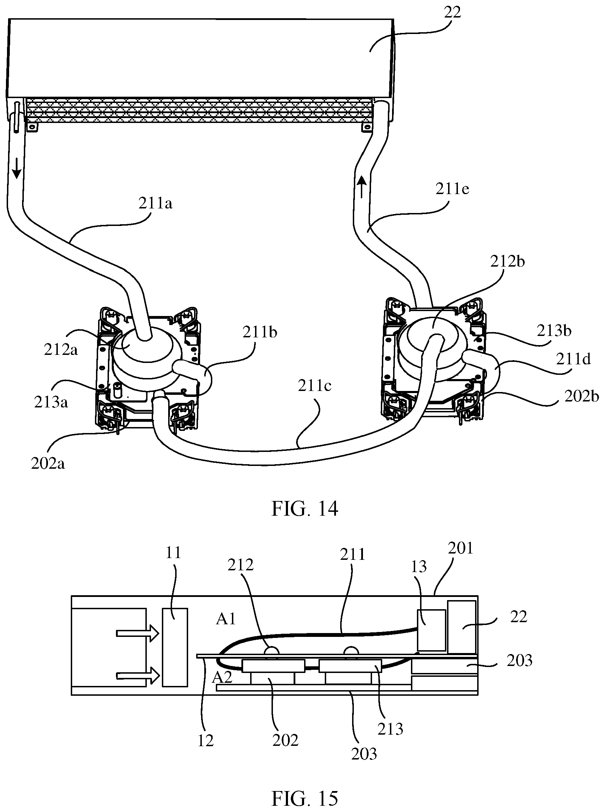

Refer to FIG. 14. The coolant flowing out of the heat exchanger 22 enters a first circulating pump 212a through a liquid-cooling pipe 211a, then enters the first circulating pump 212a through a liquid-cooling pipe 211b from the first circulating pump 212a, and enters a second circulating pump 212b from the first circulating pump 212a through a liquid-cooling pipe 211c. The second circulating pump 212b leads the coolant to a second cold plate 213b through a liquid-cooling pipe 211d, and the coolant returns from the second cold plate 213b to the heat exchanger 22 through a liquid-cooling pipe 211e. This structure is more concise and can save space.

It should be understood that the liquid-cooling structures shown in FIG. 10 to FIG. 14 are merely examples for description. In addition, because liquid cooling is performed on only two processors 202, the liquid-cooling structure is simple. By extension, when there are more than two processors 202 (or first-type components), a specific implementation of the liquid-cooling structure may be modified, integrated, and improved based on the foregoing embodiment, to obtain more diversified implementations. Details are not described herein again.

To improve the heat dissipation effect of the heat exchanger 22, as shown in FIG. 15, the air-cooling structure may further include a heat dissipation fan 13. The heat dissipation fan 13 may be specifically disposed on an air inlet side of the heat exchanger 22, and the heat dissipation fan 13 may independently provide air cooling for the heat exchanger 22, to improve an efficiency of heat exchange between the coolant in the heat exchanger 22 and the external air.

In addition, the liquid-cooling structure further includes an auxiliary heat exchanger 23. The auxiliary heat exchanger 23 may be connected to the heat exchanger 22 in series, to implement circulation of the coolant among the liquid-cooling pipe 211, the heat exchanger 22, and the auxiliary heat exchanger 23. The auxiliary heat exchanger 23 is also configured for heat exchange between the coolant and the external air. Herein, it is illustrated that there is one auxiliary heat exchanger 23. In actual application, there may be a plurality of auxiliary heat exchangers 23, and the plurality of auxiliary heat exchangers 23 are connected in series to the heat exchanger 22.

With reference to the foregoing embodiment, FIG. 16 shows a specific implementation in which the heat dissipation apparatus is laid out into the server according to this application. A front end and the tail end of the server are shown in FIG. 16. A circuit board 203 is disposed in the chassis 201 of the server, the processor 202 (equivalent to the first-type component) is coupled to the circuit board 203, and the PCIe card 204 (equivalent to the second-type component) inserted into the circuit board 203 is disposed at the tail end of the server. The system fan 11 is disposed between the circuit board 203 and the front end of the server. The system fan 11 may drive air to form an airflow along a direction from the front end of the server to the tail end, to form an air duct in the chassis 201. The airflow formed by driving the air by the system fan 11 may perform air cooling on the circuit board 201, the processor 202, and the PCIe card 204. The heat exchanger 22 in the heat dissipation apparatus is disposed at the tail end of the server, and heat dissipated from the heat exchanger 22 does not affect heat dissipation of another component. The liquid-cooling pipe 211 in the liquid-cooling structure is connected to the heat exchanger 22, and the circulating pump 212 is connected to the liquid-cooling pipe 211 to drive the coolant in the liquid-cooling pipe 211 to circulate between the liquid-cooling pipe 211 and the heat exchanger 22. The cold plate 213 that can implement heat exchange between the coolant and the processor 202 is disposed on the liquid-cooling pipe 211. Each processor 202 is correspondingly provided with one cold plate 213, and each cold plate 213 is correspondingly disposed with one circulating pump 212. Connections among the liquid-cooling pipe 211, the circulating pump 212, and the cold plate 213 may be illustrated with reference to FIG. 10 to FIG. 14. The heat exchanger 22 is also located in an air duct formed by driving the air by the system fan 11, to facilitate heat exchange between the coolant with a high temperature in the heat exchanger 22 and the external air, to complete cooling of the coolant. The heat dissipation fan 13 is disposed at an air inlet end of the heat exchanger 22, so that an air-cooling effect on the heat exchanger 22 can be improved.

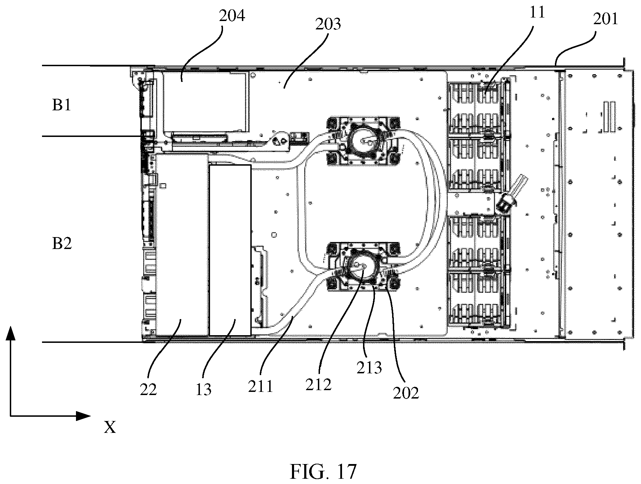

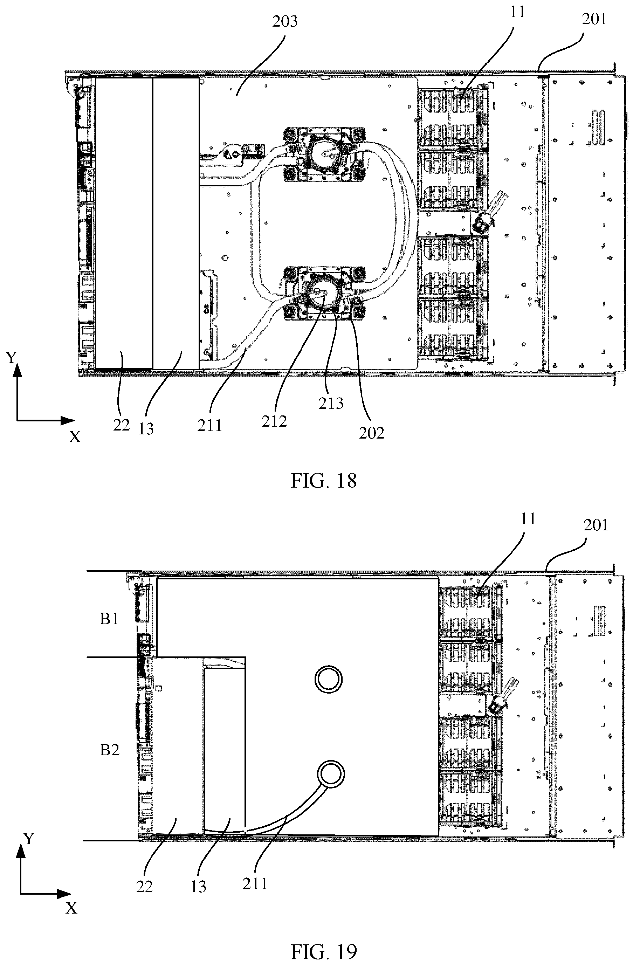

With reference to FIG. 1, refer to a top view shown in FIG. 17 in which the heat dissipation apparatus is laid out into the server. The tail end of the server is divided into a region B1 and a region B2 along a width direction X of the server, and the heat exchanger 22 may occupy only the region B2. The heat exchanger 22 is equivalent to being parallel with the PCIe card 204 in a height direction Z of the server (as shown in FIG. 1), and is also parallel with the PCIe card 204 in the width direction X of the server. Certainly, as shown in FIG. 18, in the width direction X of the server, the heat exchanger 22 occupies the entire region of the tail end of the server. In this case, in the height direction Z of the server, the heat exchanger 22 blocks the PCIe card 204. The heat exchanger 22 is equivalent to being parallel only with the PCIe card 204 in the height direction Z of the server (as shown in FIG. 1).

In the structures shown in FIG. 16 to FIG. 18, in order to clearly show the liquid-cooling structure, the separator configured to isolate the air duct is not shown. A structure of the separator 12 disposed in the air duct is shown in FIG. 19. The separator 12 separates the air duct along the height direction of the server. In a top view shown in FIG. 19, the circuit board 203, the processor 202, part of the liquid-cooling pipe 211, the cold plate 213, and the PCIe card 204 are all blocked by the separator 12 and are not shown. The circulating pump 212 is shown because higher part of the circulating pump 212 protrudes out of the separator 12. The separator 12 herein has an avoidance opening for avoiding the circulating pump 212. The air duct with the separator 12 may independently perform air cooling on the heat exchanger 22, to reduce an adverse effect caused by temperature cascading.

Based on the foregoing embodiment, this application further discloses a server having the foregoing heat dissipation apparatus. For a structure of the server, refer to FIG. 16 to FIG. 19. Details are not described herein again. It should be understood that because the foregoing heat dissipation apparatus is disposed on the server, a heat dissipation capability of the server can be improved. Based on simulation data, compared with a heat dissipation capability of a conventional common air-cooling device, a heat dissipation capability of the server disposed with the foregoing heat dissipation apparatus can be improved by more than 20%, and overall energy consumption of a system of the server can also be reduced.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application should be subject to the protection scope of the claims.

## Claims

1. A heat dissipation apparatus, used in a server, wherein the heat dissipation apparatus comprises:
an air-cooling structure, configured to perform air cooling on a first-type component and a second-type component, wherein the first-type component and the second-type component are disposed in the server, and heat generated by the first-type component is higher than heat generated by the second-type component;
a liquid-cooling structure, configured to perform liquid cooling on the first-type component; and the liquid-cooling structure comprises:
a liquid-cooling assembly, configured to conduct the heat generated by the first-type component to a coolant in a liquid supply pipe of the liquid-cooling assembly; and
a heat exchanger, configured for heat exchange between the coolant and external air, wherein the heat exchanger is located at a tail end of the server.

2. The heat dissipation apparatus according to claim 1, wherein the air-cooling structure comprises a separator, wherein the separator separates a cavity of the server into at least two air ducts, and the at least two air ducts comprise a first air duct and a second air duct; and
the heat exchanger is located at an air outlet of the first air duct.

3. The heat dissipation apparatus according to claim 2, wherein the first-type component and the second-type component are located in the second air duct.

4. The heat dissipation apparatus according to claim 3, wherein the separator is parallel to a print circuit board PCB in the server, and a distance between the separator and the highest component in the PCB is less than a height threshold.

5. The heat dissipation apparatus according to any one of claims 2 to 4, wherein a material of the separator is sheet metal or plastic.

6. The heat dissipation apparatus according to any one of claims 2 to 5, wherein the separator has a hollow-out region; and
when the separator is fastened in the cavity of the server, the hollow-out region is configured to avoid a circulating pump of the liquid-cooling assembly.

7. The heat dissipation apparatus according to any one of claims 2 to 6, wherein in a direction perpendicular to the separator, a plurality of mounting positions are disposed in the server, and the separator is detachably mounted at any one of the mounting positions.

8. The heat dissipation apparatus according to any one of claims 2 to 7, wherein the air-cooling structure further comprises a heat dissipation fan, and the heat dissipation fan is located on an air inlet side of the heat exchanger.

9. The heat dissipation apparatus according to any one of claims 2 to 8, wherein the liquid-cooling structure further comprises an auxiliary heat exchanger, and the auxiliary heat exchanger is disposed in the first air duct and is connected to the heat exchanger in series.

10. The heat dissipation apparatus according to any one of claims 1 to 9, wherein the liquid-cooling assembly comprises a liquid-cooling pipe, the coolant, and the circulating pump;
the liquid-cooling pipe is connected to the heat exchanger, and the coolant is filled in the liquid-cooling pipe and the heat exchanger; and
the circulating pump is connected to the liquid-cooling pipe to drive the coolant to circulate between the heat exchanger and the liquid-cooling pipe.

11. The heat dissipation apparatus according to claim 10, wherein the liquid-cooling assembly further comprises a cold plate, and part of the liquid-cooling pipe is encapsulated in the cold plate; and the cold plate is configured to contact the first-type component.

12. The heat dissipation apparatus according to any one of claims 1 to 11, wherein an air duct is formed in the air-cooling structure, and the heat exchanger is disposed at an air outlet of the air duct.

13. The heat dissipation apparatus according to any one of claims 1 to 12, wherein the heat exchanger has a heat exchange inner cavity and a liquid replenishment cavity located at the top of the heat exchange inner cavity; and
the heat exchange inner cavity has a liquid inlet for the coolant to flow in and a liquid outlet for the coolant to flow out, wherein the liquid replenishment cavity is filled with the coolant, and the liquid replenishment cavity is connected to the heat exchange inner cavity through a liquid replenishment channel.

14. The heat dissipation apparatus according to claim 13, wherein a volume of the coolant in the liquid replenishment cavity is not less than a liquid volume threshold, and the liquid volume threshold is a liquid loss of the coolant within a service life of the heat dissipation apparatus.

15. A server, comprising a first-type component, a second-type component, and the heat dissipation apparatus according to any one of claims 1 to 14.
